## Europäisches Patentamt

## European Patent Office

## Office européen des brevets

(19)

(11) Numéro de publication: **0 260 258 B1**

(12) **FASCICULE DE BREVET EUROPEEN**

(45) Date de publication du fascicule du brevet:
**24.05.89**

(21) Numéro de dépôt: **86902414.1**

(22) Date de dépôt: **11.04.86**

(86) Numéro de dépôt international:
**PCT/FR 86/00118**

(87) Numéro de publication internationale:
**WO 86/06024 (23.10.86 Gazette 86/23)**

(51) Int. Cl.⁴: **B 32 B 27/20, B 44 D 3/18, G 03 F 7/02, G 03 F 1/00**

(54) **FILMS POLYESTERS, COMPOSITES, ETIRES UTILISABLES NOTAMMENT POUR ARTS GRAPHIQUES.**

(30) Priorité: **15.04.85 FR 8505841**

(43) Date de publication de la demande:
**23.03.88 Bulletin 88/12**

(45) Mention de la délivrance du brevet:
**24.05.89 Bulletin 89/21**

(84) Etats contractants désignés:
**AT BE CH DE FR GB IT LI LU NL SE**

(56) Documents cités:
**EP-A- 0 035 835**
**EP-A- 0 053 498**
**EP-A- 0 124 310**
**FR-A- 1 469 837**

(73) Titulaire: **RHONE POULENC FILMS, 25, quai Paul Doumer, F-92408 Courbevoie (FR)**

(72) Inventeur: **EYRAUD, Marcel, 7, rue des Noyers, F-69005 Lyon (FR)**

(74) Mandataire: **Rioufrays, Roger et al, RHONE-POULENC INTERSERVICES Service Brevets Chimie Centre de Recherches de Saint-Fons B.P. 62, F-69192 Saint-Fons Cédex (FR)**

# Description

La présente invention concerne des films composites polyesters étirés notamment pour arts graphiques ayant une bonne machinabilité, une excellente transparence et particulièrement adaptés à l'utilisation dans les machines fabriquant les formes imprimantes pour plaques offset.

Les films utilisés dans l'industrie graphique sont des films relativement épais (épaisseur en général comprise entre 30 et 300 µm) présentant une transparence élevée mais dont il serait souhaitable d'accroître la machinabilité; par machinabilité on entend l'aptitude du film à être manipulé commodément, sans difficultés particulières lors de la mise en œuvre (blocage...) et sans perte des qualités du film (modification de ses paramètres de surface, dégradation, usure, rayure, cassure...). Cette aptitude peut parfois être désignée sous le terme usinabilité. En arts graphiques les processus de mise en œuvre sont essentiellement: enroulement, désenroulement, déramage (par exemple en photocopie), placage (par exemple lors de la préparation de formes imprimantes pour machines à répéter et châssis de copie).

Il est bien connu que les propriétés de transparence et de machinabilité sont contradictoires et qu'il est nécessaire dans chaque utilisation de trouver le meilleur compromis entre elles.

On sait en effet que la machinabilité peut être obtenue en introduisant dans le polymère avec lequel le film est constitué, de fines particules généralement minérales, donnant à la surface du film des protubérances assurant les bonnes propriétés de glissant nécessaire au montage correct des bobines. La présence de ces charges réduit évidemment la transparence du film et ne permet pas d'obtenir une faible valeur pour le pourcentage de lumière dispersée dans la lumière transmise.

Les techniques de coextrusion permettent de fabriquer des films composites ayant des fines couches extérieures chargées [amenant donc le glissant] sans introduire de charge dans la couche centrale: on parvient donc à des films présentant un compromis intéressant entre la transparence et la machinabilité.

Des films complexes ou multicouches utilisés dans les arts graphiques sont par exemple décrits dans les brevets français 1 469 837, 2 177 471 et 2 232 426.

Dans le brevet français 1 469 837 sont décrits des films composites étirés pour arts graphiques et constitués par au moins une fine couche extérieure chargée contiguë à une couche plus épaisse non chargée. Les particules ont une dimension moyenne comprise entre 2 et 20 µm et sont introduites en quantité allant de 500 à 50 000 ppm. Ces films dans lesquels l'épaisseur de la couche externe représente de 5 à 25% de l'épaisseur totale du stratifié sont des films minces, d'épaisseur totale comprise entre 25 et 50 µm; ces films ont une bonne machinabilité et présentent vis-à-vis du film monocouche de même épaisseur une transparence considérablement accrue.

Les brevets français 2 177 471 et 2 232 426 de la titulaire décrivent des films coextrudés dont une couche extérieure contient des fines particules provenant du résidu du catalyseur et amenant ainsi les propriétés de glissant.

On a préparé également des films épais éventuellement coextrudés ayant des bonnes propriétés frictionnelles (rugosité totale comprise entre 0,050 et 0,3 µm dans des conditions de mesure bien définies) et ayant un pourcentage de lumière dispersée (désignée également dans la technique considérée sous le terme de haze) particulièrement faible en introduisant dans la pellicule avant biétirage une très faible quantité (inférieure à 200 ppm) d'une charge fine constituée par un mélange de particules de nature chimique différente et ayant chacune une taille médiane en poids de particule supérieure à 0,4 µm [demandes de brevets japonais de Teijin Kokaï 53/125 479 et 54/15 979].

On a également décrit dans la demande de brevet européen 0 124 310 des films thermoplastiques composites minces de polypropylène, à couches externes chargées, à haze faible, machinables [coefficient de friction faible], contenant une quantité relativement élevée de charge [5000 à 10 000 ppm] et ayant un diamètre compris entre 0,2 et 5 µm et utilisable dans le domaine de l'emballage où l'on met à profit leurs propriétés de scellabilité. Ces films ont une épaisseur inférieure ou égale à 20 µm. Il est suggéré dans ce document la possibilité de remplacer le polypropylène par d'autres matériaux thermoplastiques variés mais dans l'application visée la transposition n'est pas en général possible compte tenu des trop grandes différences des propriétés des polymères mis en œuvre.

Pour les applications arts graphiques une étape importante concerne la fabrication de la forme imprimante nécessaire pour la fabrication des plaques offset. Celle-ci est préparée à l'aide de clichés de montage réalisés en films thermoplastiques et généralement en polyester. Outre la transparence, la machinabilité, le caractère anti-Newton [propriété consistant à éviter l'apparition d'anneaux de Newton par interférence lumineuse lorsque l'on plaque deux films l'un sur l'autre ou lorsque l'on dispose un film sur une plaque de verre], les clichés de montage en films polyester doivent pouvoir se prêter à une mise en œuvre aisée et notamment être mis en place à cadence rapide dans les machines industrielles. Or dans la fabrication des plaques offset, l'étape de placage sous vide du cliché de montage dans les châssis d'exposition UV est souvent longue et de ce fait détermine la productivité générale. Ceci est particulièrement vrai pour la fabrication de grandes plaques de surface habituellement comprises entre 0,7 et 2,5 m² où le temps de placage sur châssis peut atteindre 30 minutes.

Les films polyesters usuels conviennent mal dans ce type d'application; une solution a cependant été trouvée par enduction de résine chargée de fines particules sur un film de polyester transparent. Mais ces films exigent une enduction en reprise sur un film fini ayant déjà subi un traitement de biétirage.

Dans le domaine des films directement obtenus sur lignes industrielles il n'existe pas à ce jour de solution. Il se posait donc le problème de mettre au point des films polyesters, obtenables directement sur machines industrielles sans mettre en œuvre de traitement d'enduction, convenant dans l'application arts graphiques précédemment définie, et ayant simultanément une bonne transparence, une bonne machinabilité, le caractère anti-Newton et utilisable à cadence élevée notamment dans les machines de fabrication des formes imprimantes.

L'invention répond précisément à ce but et revendique des films polyester composites étirés, épais, directement obtenus sur machine industrielle sans enduction, ces films ayant une grande transparence [pourcentage de lumière dispersée transmise inférieur à 7], une épaisseur comprise entre 40 et 300 µm, et une rugosité de surface élevée permettant une cadence d'utilisation élevée et l'élimination des phénomènes d'anneaux de Newton. Ces films présentent un faible coefficient de friction.

Plus précisément l'objet de la présente invention est constitué par des films polyester composites épais d'épaisseur comprise entre 40 et 300 µm, étirés, cristallins ou semi-cristallins constitués par une couche (A), étirée, d'épaisseur $e_1$, cette couche (A) étant essentiellement non chargée et étant recouverte sur au moins une de ses faces par une couche mince (B) d'épaisseur $e_2$, étirée, la couche (B) ayant une rugosité totale supérieure à 0,3 µm, caractérisé en ce que:
— le rapport des épaisseurs de la couche (B) par rapport à la couche (A) représenté par $e_2/e_1$ est inférieur à 5%
— le pourcentage de lumière dispersée du film composite est inférieur à 7
— la couche (B) contient de 0,02 à 1% en poids d'une charge de particules inertes de diamètre médian en volume au moins égal à l'épaisseur de cette couche entre 1 et 10 µm.

Les films de la présente invention sont particulièrement remarquables en ce sens qu'ils permettent des temps de mises en place sur châssis beaucoup plus courts [entre 5 à 20 fois plus courts que ceux relatifs aux films standards] tout en ayant une excellente transparence, le caractère anti-Newton ainsi qu'une bonne machinabilité.

On observe en outre que les images obtenues à l'aide des films de la présente invention ont bien souvent des meilleures qualités de définition de l'image que celles obtenues avec les films classiques.

Avantageusement les films de l'invention ont une épaisseur supérieure ou égale à 50 µm.

La rugosité de la couche (B) est apportée par introduction de fines particules inertes dans la composition polymérique destinée à produire après étirage la couche (B).

Le diamètre médian en volume de la charge de particules est compris préférentiellement entre 1 et 5 µm. La teneur en charge introduite est comprise préférentiellement entre 0,2 et 0,5% en poids.

La nature des particules inertes ajoutées peut être très variée: il peut s'agir de particules minérales (oxydes ou sels des éléments des groupes II, III et IV de la classification périodique des éléments), ou encore de particules polymériques. A titre illustratif on peut citer parmi les charges utilisables: la silice, les silicoaluminates, le carbonate de calcium, MgO, $Al_2O_3$, $BaSO_4$, $TiO_2$. Avantageusement on utilisera à titre de charge du carbonate de calcium (variété naturelle ou obtenu par précipitation) qui permet dans cette technique d'obtenir une valeur particulièrement basse du pourcentage de lumière dispersée.

La couche (A) peut éventuellement être elle-même une couche composite.

Le film composite de la présente invention peut comporter une seule couche (B). Il s'agira alors d'un film bicouche transparent à rugosités dissymétriques qui comportera une couche relativement lisse et une couche rugueuse.

Le film composite de la présente invention peut être un film constitué par une couche (A) et deux couches (B) telles que précédemment définies. Il s'agira dans cette hypothèse de films rugueux sur ses faces et pouvant être symétrique ou dissymétrique selon que les couches (B) sont identiques ou non.

Préférentiellement le film composite de l'invention comportera deux couches (B) dont les caractéristiques seront identiques ou peu différentes (films symétriques ou dissymétriques).

Selon une variante de l'invention le rapport des épaisseurs des deux couches (B) et (A) sera avantageusement à 3%, cette modalité permettant d'élever encore la transparence.

Ainsi les films polyesters de la présente invention ont une épaisseur comprise entre 40 et 300 µm et comportent une couche (A) épaisse recouverte en général sur au moins une surface par une couche (B) très mince dont l'épaisseur sera comprise en général entre 0,3 et 3 µm et préférentiellement entre 0,5 et 2 µm.

Selon une autre variante de la présente invention les films polyesters composites auront pour le pourcentage de lumière dispersée transmise une valeur inférieure à 5.

Les couches (A) et (B) constituant le film complexe de la présente invention sont comme on l'a déjà dit constitués par des polyesters cristalins ou semi-cristallins. Au sens de l'invention, on entend par polyester cristallin ou semi-cristallin un polyester qui après extrusion en fondu à travers une filière plate puis biétirage du film amorphe, conduit à un film à caractère cristallin ou semi-cristallin et ayant des propriétés satisfaisantes lui permettant de constituer un film support ou une couche support d'un film composite [module élevé, stabilité dimensionnelle].

L'évidence de l'aptitude à la cristallisation ou de la cristallinité des polymères est révélée par tout moyen connu du spécialiste comme par exemple par analyse thermique différentielle où l'on met en évidence des pics de cristallisation ou de fusion cristalline. Dans ce contexte on peut se référer à l'article de S.H. Lin et J.L. Koenig dans Journal of Polymer Science Polymer Symposium 71, 121-135 (1984); le taux de cristallinité de la couche de polymère dans le film croît avec l'élévation de la surface du pic observé en analyse thermique différentielle et est évidemment fonction de la nature du polymère et des traitements physiques [par exemple: étirage] et/ou thermiques qu'il a subi [thermofixation].

La mesure de densité [variation importante de la densité] permet également de vérifier de manière simple si le polyester est à l'état cristallin ou semi-cristallin.

Il doit être entendu dans le cadre de la présente invention que l'on désigne par film étiré tout film obtenu après au moins un étirage monodirectionnel effectué sur un film amorphe de manière à conférer au film un ensemble satisfaisant de propriétés mécaniques (module élevé, bonne stabilité dimensionnelle). Il peut donc s'agir d'un monoétirage ou d'un biétirage effectué successivement ou simultanément dans deux directions en général orthogonales ou encore de séquences d'au moins 3 étirages où la direction d'étirage est changée à chaque séquence. Par ailleurs, chaque étirage monodirectionnel peut lui-même être effectué en plusieurs étapes. On pourra ainsi associer des séquences d'étirage comme par exemple deux traitements successifs de biétirage, chaque étirage pouvant être effectué en plusieurs phases.

Enfin selon une variante avantageuse de la présente invention, les films tels que précédemment définis ont subi un traitement de biétirage dans deux directions orthogonales entre elles.

Les films composites de l'invention sont des films en polyester, pouvant être constitués par tout polyester filmogène linéaire ou essentiellement linéaire et conduisant à des polyesters cristallins ou semi-cristallins. Les polyesters sont obtenus à partir d'un ou de plusieurs diacides carboxyliques ou de leurs esters d'alkyle inférieur (acide téréphtalique, acide isophtalique, acide naphtalènedicarboxylique-2,5, acide naphtalènedicarboxylique-2,6, acide naphtalènedicarboxylique-2,7, acide succinique, acide sébacique, acide adipique, acide azélaïque, acide diphényldicarboxylique et acide hexahydrotéréphtalique) et d'un ou de plusieurs diols ou polyols comme l'éthylèneglycol, le propanediol-1,3, le butanediol-1,4, le néopentylglycol et le cyclohexanediméthanol-1,4, les polyoxyalkylèneglycol (polyoxyéthylèneglycol, polyoxypropylèneglycol ou leurs copolymères statistiques ou séquencés).

Généralement, les polyesters utilisés sont des homopolymères ou des copolymères comportant essentiellement des motifs téréphtaliques d'alkylène; de préférence lesdits polyesters comportent au moins 80% en poids de motifs téréphtalate d'éthylèneglycol et, plus préférentiellement encore, au moins 90% en poids de tels motifs. Le polyester peut être également un mélange de plusieurs polycondensats dont 80% en poids et de préférence 90% en poids sont du polytéréphtalate d'éthylèneglycol.

Avantageusement, le polyester est un polytéréphtalate d'éthylèneglycol dont la viscosité intrinsèque VI mesurée à 25° C dans l'o-chlorophénol est comprise entre 0,6 et 0,75 dl/g.

La préparation de tels polyesters est connue en soi. Les catalyseurs, stabilisants et additifs mis en œuvre ne sont pas critiques. Ces derniers doivent être cependant choisis de telle manière qu'ils n'engendrent pas, au sein de la résine polyester allant constituer la couche (A), des particules solides provenant des résidus catalytiques et susceptibles de modifier de manière néfaste l'état de surface et la transparence. Eventuellement, les catalyseurs peuvent engendrer des particules de taille minime dont les dimensions n'influent pas sur l'état de surface du film.

Les charges seront de préférence introduites en fin de phase d'estérification ou d'interéchange, sous la forme d'une suspension des particules dans le diol utilisé (ou encore selon une variante possible dans l'un des diols utilisés).

De telles suspensions peuvent être réalisées par simple broyage de la charge ou des charges dans le diol approprié; il peut également s'agir d'un broyage suivi d'une centrifugation ou d'une filtration qui permet d'éliminer les particules les plus grosses et les agglomérats de particules; les suspensions de charge peuvent aussi être homogénéisées par des techniques connues, telles que par exemple un traitement approprié à l'aide d'ultrasons. Ces techniques permettent d'ajuster le diamètre médian en volume et les distributions granulométriques.

Il est également possible de préparer préalablement un lot de polyester contenant les charges puis de mélanger ce polyester avec un polyester non chargé avant l'extrusion du film amorphe.

Les films polyesters composites de la présente invention peuvent être obtenus par des procédés variés conventionnels. Ceux-ci sont avantageusement obtenus par coextrusion d'au moins un polyester chargé conduisant à des films amorphes et devenant cristallins après avoir été soumis à un traitement d'étirage puis à un traitement de thermofixation. L'étirage peut être effectué de manière successive: tout d'abord un étirage dans la direction de la machine (étirage longitudinal) suivi d'un étirage perpendiculaire à la direction de la machine (étirage transversal) ou l'inverse, c'est-à-dire un étirage transversal suivi d'un étirage longitudinal. Les données qui vont suivre se rapportent plus spécialement aux polyesters et notamment au polytéréphtalate d'éthylèneglycol.

Généralement, pour ce dernier, l'étirage longitudinal est effectué à un taux de 3 à 5 (c'est-à-dire que la longueur du film étiré représente de 3 à 5 fois la longueur du film amorphe) et à une température de 80 à 100° C pour le polyester et l'étirage transversal est effectué avec un taux de 3 à 5 à une température de 90 à 120° C.

L'étirage peut également être effectué simultanément dans deux directions orthogonales entre elles (habituellement sens longitudinal et sens transversal), par exemple avec un taux de 3 à 5 dans chaque sens et à une température de 80 à 140° C.

Selon le choix des conditions d'étirage il est possible de générer des morphologies particulières de surface telles que la présence de cavités entourant une protubérance et ceci par le choix du polymère et/ou des conditions d'étirage.

Après l'étirage le film est thermofixé de manière également connue en soi, en général à une température de 180 à 230° C.

L'invention concerne également les procédés d'obtention des films composites tels que définis précédemment.

L'invention concerne en particulier un procédé d'obtention de films polyester tels que définis précédemment, par coextrusion puis étirage et thermofixation d'au moins un polyester non chargé et d'un polyester chargé, le procédé étant caractérisé en ce que:

— le polyester chargé représente au plus en poids 5% du polyester non chargé

— le polyester chargé contient de 0,02 à 1% en poids d'une charge fine dont le diamètre médian en volume est compris entre 1 et 10 µm et préférentiellement entre 1 et 5.

Les films composites selon l'invention, avec leur rugosité élevée et notamment lorsque celle-ci est supérieure à 0,4 µm sont particulièrement intéressants dans l'application des arts graphiques compte tenu notamment de leur transparence, de leur caractère anti-Newton, et de la possibilité de les utiliser à cadence élevée dans les machines de photogravure. Mais les films composites de la présente invention sont également très intéressants dans le domaine de la photocopie où l'on exige des films une bonne machinabilité et un déramage rapide; les films de l'invention sont utilisables avec alimentation par paquets en continu alors que l'emploi de films polyester classiques ne permet que l'alimentation feuille à feuille.

On peut le cas échéant améliorer par enduction les propriétés d'usage du film, en lui conférant un caractère antistatique à l'aide de revêtements connus, ou encore de meilleures propriétés d'accrochage vis-à-vis des couches d'enduction ultérieures.

Les propriétés des films de la présente invention ainsi que les caractéristiques des charges introduites sont mesurées de la manière suivante:

### Caractère anti-Newton:

Le caractère anti-Newton peut être vérifié en impressionnant une plaque offset positive à travers deux feuilles du film à tester, en utilisant une trame polychrome à 50%. Après développement on ne doit voir aucun anneau de Newton sur la plaque. On peut également utiliser le test suivant: en reproduction par contact d'un original sur un film argentique, on fait disparaître les anneaux de Newton sur la reproduction en intercalant le film revendiqué entre vitre et original à reproduire par contact.

### Rugosités:

La rugosité d'un film s'exprime généralement au moyen de deux valeurs:

— une valeur correspondant à la rugosité totale $R_t$

— une valeur correspondant à la rugosité moyenne $R_a$ (également appelée CLA selon les termes anglais «center line average»).

La rugosité totale $R_t$ et la rugosité moyenne $R_a$ sont définies et leurs mesures sont décrites dans la norme internationale ISO R 468.

La rugosité est mesurée selon la norme internationale à l'aide d'un appareil Perthen W 5 B.

La mesure correspond à la moyenne de 10 résultats, les divers facteurs de mesure étant choisis de la manière suivante: valeur de la longueur d'onde limite ou cut-off: 0,08 µm; longueur de palpage: 1,5 mm; rayon de courbure du palpeur: 3 µm; force d'appui du palpeur: 30 mg.

### Pourcentage de lumière dispersée transmise (haze):

Cette mesure caractérise la turbidité des films; elle est effectuée selon la norme ASTM D 100.

### Diamètre médian en volume:

Le diamètre médian en volume est le diamètre sphérique correspondant à 50% du volume de l'ensemble des particules lu sur la courbe de distribution cumulée reliant le % volumique au diamètre des particules.

Par diamètre équivalent sphérique d'une particule, on entend le diamètre d'une sphère ayant un volume équivalent à celui de la particule.

La courbe de distribution des tailles de particules est établie selon les diverses méthodes décrites dans l'art antérieur et notamment par photométrie sous centrifugation à l'aide de l'appareillage HORIBA/CAPA 500.

Cette méthode permet de mesurer la variation d'absorbance d'une suspension dans laquelle les particules sédimentent en fonction du temps t.

Cette absorbance est définie par la relation $Ln\dfrac{Io}{I}$ et elle est reliée aux caractéristiques de la suspension par la formule:

$$\left[ Ln\ \dfrac{I_o}{I} \right]_{d_x} = K\ E\ (d_x)\ .\ n(d_x)\ .\ (d_x)^2$$

$I_o$: lumière transmise par le liquide pur

$I$: lumière transmise par la suspension

$K$: constante fonction de la concentration de la suspension et de l'épaisseur de la cellule

$E\ (d_x)$: coefficient d'extinction (pris égal à 1 quel que soit le diamètre)

$n(d_x)$: nombre de particules de diamètre $d_x$.

La vitesse de sédimentation est reliée au diamètre équivalent sphérique des particules par la formule de Stockes.

(cf. ouvrage de T. Allen: «Particle Size Measurement», Third edition 1981.)

### Mesure du coefficient de friction

Ç'est la détermination de la friction film/film mesurée au démarrage (coefficient statique) et en régime (valeur dynamique) quand un film se déplace par rapport à un autre à faible vitesse.

Cette mesure est normalisée (norme 311 A British Standard 2782).

*Test de placage sur châssis de copie [printing-down frames]*

Des tests de mise en place par placage dans des châssis industriels ont été effectués sur des clichés grands formats ayant les dimensions suivantes: 700 × 1000 mm.

Une étude systématique a permis de hiérarchiser de façon correspondante les films à l'aide des cotations suivantes:
- cote C: comportement des films polyester usuels
- cote B: amélioration sensible mais inférieure à 50%
- cote A: temps de placage très diminué avec amélioration de la productivité supérieure à 50%.

*Exemple 1:*

On réalise un film composite trois couches de polytéréphtalate d'éthylèneglycol, les deux couches externes B et B' étant chargées, la couche interne A ne l'étant pas. Les polymères de polytéréphtalate d'éthylèneglycol ont été obtenus par transestérification à partir de téréphtalate de diméthyle et d'éthylèneglycol en utilisant comme catalyseur d'interéchange l'acétate de manganèse, suivi d'une polycondensation avec comme catalyseur l'oxyde d'antimoine, qui amène la viscosité du polymère à $VI = 0,64$.

La charge présente dans les couches externes au taux pondéral de 0,35% (soit 3500 ppm) est un carbonate de calcium introduit sous forme de suspension glycolique incorporée dans le milieu réactionnel en fin d'interéchange. La répartition granulométrique est caractérisée par le diamètre médian en volume: $\emptyset_v$ médian $= 3$ μm (mesuré à l'HORIBA/CAPA 500).

On obtient ainsi, après un biétirage effectué dans les conditions habituelles (longitudinal puis transversal), un film présentant le caractère anti-Newton avec les caractéristiques suivantes:
- épaisseur totale du film: 125 μm
- épaisseur de chaque couche de surface: 1 μm (rapport $e_2/e_1 = 0,813\%$)
- pourcentage de lumière dispersée: 3
- rugosité $R_t = 0,90$ μm
- rugosité $R_a = 0,08$ μm
- coefficient de friction statique $\mu_s = 0,38$
- coefficient de friction dynamique $\mu_d = 0,35$
(les coefficients de friction sont mesurés par frottement d'une face 1 du film sur la face 2).

Ce film permet des mises en place rapide des documents dans les châssis de copie (fabrication des plaques offset). Sa cotation est A au test de placage sur châssis de copie.

*Exemple 2:*

On réalise un film dissymétrique à 3 couches en polytéréphtalate d'éthylèneglycol constitué de la façon suivante:

1 couche externe B d'épaisseur $e_2 = 0,5$ μm, chargée $BaSO_4$: à 0,2% - $\emptyset_v$ médian $= 4$ μm.

1 couche interne A non chargée: 172,5 μm

1 couche externe B' d'épaisseur $e'_2 = 2$ μm, chargée comme la couche B.

$e_2/e_1 = 1,16\%$
$e'_2/e_1 = 2,32\%$
Résultats:
- rugosité face B: $R_t = 0,4$ μm
- rugosité face B': $R_t = 1$ μm
- pourcentage de lumière dispersée: 3,5
- coefficients de friction:
  $\mu_s = 0,38$
  $\mu_d = 0,35$

Ce film présente le caractère anti-Newton en utilisant la face B'. Sa cotation est A au test de placage sur châssis de copie.

*Exemple 3:*

On réalise un film dissymétrique à trois couches ayant une épaisseur totale de 125 μm. Les couches de surface ont respectivement une épaisseur de 0,5 μm (couche B) et 2 μm (couche B') et sont chargées de silice syloïd 244[R]
- $\emptyset_v$ médian: 2 μm
- taux pondéral: 0,2% (dans les 2 couches)
- $e_2/e_1$: 0,4%
- $e'_2/e_1$: 1,60%
Caractéristiques du film:
- pourcentage de lumière dispersée: 3
- rugosités $R_t$: 0,65 μm (couche B')
  $R_t$: 0,3 μm (couche B)
- coefficient de friction:
  $\mu_s$: 0,4
  $\mu_d$: 0,36

Ce film est anti-Newton. Il a fait l'objet d'une fabrication à l'échelle industrielle. Il est utilisable à cadence élevée dans les machines destinées à la fabrication de formes imprimantes pour plaques offset. Sa cotation est A au test de placage sur châssis de copie.

*Exemple 4:*

On réalise un film dissymétrique à trois couches ayant une épaisseur totale de 125 μm. Les couches de surface ont respectivement une épaisseur de 0,5 μm (couche B) et 2 μm (couche B') et sont chargées de carbonate de calcium
- $\emptyset_v$ médian: 2,1 μm
- taux pondéral: 0,25% (dans les 2 couches)
- $e_2/e_1$: 0,4%
- $e'_2/e_1$: 1,60%

*Caractéristiques du film:*

- pourcentage de lumière dispersée: 3
- rugosités $R_t$: 0,45 μm (couche B')
  $R_t$: 0,25 μm (couche B)
- coefficient de friction:
  $\mu_s$: 0,4
  $\mu_d$: 0,36

Le film est utilisable à cadence élevée dans les machines destinées à la fabrication de formes imprimantes. Sa cotation est A.

*Exemple 5:*

On réalise sur ligne industrielle un film symétrique à trois couches ayant une épaisseur totale de 170 μm. Les couches de surface ont une épaisseur de 1,5 μm et sont chargées de silice

— $\emptyset_v$ médian: 1,23 µm
— taux pondéral: 0,25% (dans les 2 couches)
— $e_2/e_1$: 0,9%
— $e'_2/e_1$: 0,9%

*Caractéristiques du film:*

poucentage de lumière dispersée: 4,3
— rugosités $R_t$: 0,72 µm
— coefficient de friction:
  $\mu_s$: 0,39
  $\mu_d$: 0,29
Ce film est anti-Newton. Il est utilisable à cadence élevée dans les machines destinées à la fabrication de formes imprimantes pour plaques offset. Sa cotation est A au test de placage sur châssis de copie.

*Exemples comparatifs*

A titre comparatif on effectue d'autres essais dans lesquels on modifie l'épaisseur globale du film, la quantité de charge, le diamètre médian de la charge, et mesure les propriétés des films [haze, rugosité, coefficient de frottement] et détermine la cotation au test de placage sur châssis: les résultats sont les suivants:

| Contre exemples | Epaisseurs en µm | | Charge | | Haze | Rugosités (µm) | | Test de placage sur châssis Catégorie |
|---|---|---|---|---|---|---|---|---|
| | Totale | Couche extérieure | Diamètre médian $\emptyset_v$ (µm) | Quantité (ppm) | | $R_t$ | $R_a$ | |
| 1 | 121 | 1,5 | 0,6 | 800 | 0,9 | 0,1 | 0,01 | C |
| 2 | 50 | 1,5 | 1,23 | 11000 | 16,2 | 1,15 | 0,05 | A |
| 3 | 50 | 2,0 | 0,8 | 7000 | | | | C |
| 4 | 23 | 1,0 | 1,23 | 2000 | 3,6 | 0,99 | 0,02 | B |
| 5 | 23 | 1,0 | 0,3 | 2000 | 1,2 | 0,23 | 0,01 | C |
| 6 | 12 | 0,45 | 1,23 | 2000 | 3,4 | 0,71 | 0,021 | C |
| 7 | 12 | 0,45 | 1,23 | 10000 | 12,8 | | | B |
| 8 | 12 | 0 | 1,23 | 3000 | 2,5 | | | C |

Conclusions: pour avoir des films possédant à la fois une bonne transparence, une rugosité élevée, et ayant une excellente vitesse de plaçage sur châssis, il faut:
— utiliser des films épais,
— choisir des charges particulières ayant des diamètres moyens adaptés et utiliser des quantités appropriées de charge.

On observe par ailleurs que tous les films sont machinables [coefficient de friction statique $\leqslant 0,50$; coefficient de friction dynamique $\leqslant 0,40$].

**Revendications**

1. Films polyester composites, épais d'épaisseur comprise entre 40 et 300 micromètres, étirés, cristallins ou semi-cristallins constitués par une couche (A) étirée, d'épaisseur $e_1$, cette couche étant essentiellement non chargée et étant recouverte sur au moins une de ses faces par une couche mince (B), cette couche (B) étirée, d'épaisseur $e_2$ ayant une rugosité totale supérieure à 0,3 micromètre, caractérisés en ce que:
— le rapport des épaisseurs des couches (B) et (A) représenté par $e_2/e_1$ est inférieur à 5%;
— le pourcentage de lumière dispersée transmise du film composite est inférieur à 7;
— la couche (B) contient de 0,02 à 1% en poids d'une charge de particules inertes de diamètre médian en volume au moins égal à l'épaisseur de cette couche et compris entre 1 et 10 micromètres.

2. Films selon la revendication 1 dans lesquels le rapport des épaisseurs des deux couches (B) et (A) est inférieur à 3%.

3. Films selon l'une des revendications précédentes ayant une valeur du pourcentage de lumière dispersée transmise inférieure à 5.

4. Films selon l'une des revendications 1 à 3, caractérisés en ce qu'ils sont en polytéréphtalate d'éthylèneglycol.

5. Procédé d'obtention de films selon l'une des revendications précédentes par coextrusion puis étirage et thermofixation d'au moins un polyester non chargé et d'un polyester chargé, le procédé étant caractérisé en ce que:
— le polyester chargé représente au plus en poids 5% du polyester non chargé;
— le polyester chargé contient de 0,02 à 1% en poids d'une charge fine dont le diamètre médian en volume est compris entre 1 et 10 micromètres.

6. Procédé selon la revendication 5 dans lequel le diamètre médian en volume de la charge est compris entre 1 et 5 micromètres.

7. Application des films composites selon l'une des revendications 1 à 4 pour les applications arts graphiques et notamment pour la fabrication de forme imprimante pour plaques offset.

**Patentansprüche**

1. Gestreckte, kristalline oder halbkristalline Polyesterkompositfolien mit einer Dicke zwischen 40 und 300 µm, bestehend aus einer gestreckten Schicht (A) mit einer Dicke $e_1$, wobei diese Schicht im wesentlichen nicht füllstoffhaltig ist und auf mindestens einer Seite bedeckt ist von einer dünnen Schicht (B), wobei die gestreckte Schicht (B) mit einer Dicke $e_2$ eine Gesamtrauhigkeit über 0,3 µm aufweist, dadurch gekennzeichnet, dass

— das Verhältnis der Dicken der Schichten (B) und (A) angegeben durch $e_2/e_1$ unter 5% liegt;
— der Prozentsatz des gestreuten, durch die Kompositfolie hindurchgehenden Lichtes weniger als 7 beträgt;
— die Schicht (B) 0,01 bis 1 Gew.-% Füllstoff in Form inerter Teilchen mit einer mittleren Volumendurchmesser, der mindestens gleich ist der Dicke dieser Schicht und zwischen 1 und 10 µm liegt, enthält.

2. Folien nach Anspruch 1, bei denen das Verhältnis der Dicken der beiden Schichten (B) zu (A) kleiner als 3% ist.

3. Folien nach einem der vorangehenden Ansprüche mit einem Prozentsatz für das gestreute hindurchgehende Licht unter 5.

4. Folien nach einem der Ansprüche 1 bis 4, dadurch gekennzeichnet, dass sie aus Polyethylenglykolpolyterephthalat bestehen.

5. Verfahren zur Herstellung der Folien nach einem der vorangehenden Ansprüche durch gemeinsames Extrudieren und anschliessendes Strecken und thermisches Fixieren mindestens eines nicht füllstoffhaltigen Polyesters und eines füllstoffhaltigen Polyesters, dadurch gekennzeichnet, dass

— der füllstoffhaltige Polyester höchstens 5 Gew.-% des nicht füllstoffhaltigen Polyesters ausmacht;
— der füllstoffhaltige Polyester 0,02 bis 1 Gew.-% eines feinen Füllstoffs enthält, dessen mittlerer Volumendurchmesser zwischen 1 und 10 µm liegt.

6. Verfahren nach Anspruch 5, wobei der mittlere Volumendurchmesser des Füllstoffs zwischen 1 und 5 µm liegt.

7. Anwendung der Kompositfolien nach einem der Ansprüche 1 bis 4 für graphische Zwecke, insbesondere zur Herstellung von Druckformen für Offsetplatten.

## Claims

1. Crystalline or semi-crystalline stretched thick polyester composite films having a thickness within the range 40 to 300 micrometers, formed by a stretched layer (A) of thickness $e_1$, this layer being substantially unfilled and covered on at least one of its faces by a thin layer (B), this stretched layer (B) of thickness $e_2$ having a total surface roughness greater than 0.3 micrometers, characterized in that:

— the ratio of the thicknesses of the layers (B) and (A) represented by $e_2/e_1$ is less than 5%;
— the percentage of scattered light transmitted by the composite film is less than 7;
— layer (B) contains from 0.02 to 1% by weight of a filler comprising inert particles having a volume-distributed median diameter at least equal to the thickness of this layer and being within the range 1 to 10 micrometers.

2. Films according to Claim 1 in which the ratio of the thicknesses of the two layers (B) and (A) is less than 3%.

3. Films according to one of the preceding claims having a value for the percentage of scattered light transmitted less than 5.

4. Films according to one of Claims 1 to 3, characterized in that they are made of polyethylene terephthalate.

5. Process for producing films according to one of the preceding claims by coextrusion then stretching and thermo-fixing from at least one unfilled polyester and one filled polyester, the process being characterized in that:

— the filled polyester represents at most 5% by weight of the unfilled polyester;
— the filled polyester contains from 0.02% to 1% by weight of a fine filler whose volume-distributed median diameter is within the range 1 to 10 micrometers.

6. Process according to Claim 5 in which the volume-distributed median diameter of the filler is within the range 1 to 5 micrometers.

7. Application of composite films according to one of Claims 1 to 4 for graphic arts applications and particularly for producing printing form for offset plates.